(19) Europäisches Patentamt
European Patent Office
Office européen des brevets

(11) **EP 4 583 330 A1**

(12) **EUROPEAN PATENT APPLICATION**
published in accordance with Art. 153(4) EPC

(43) Date of publication:
**09.07.2025 Bulletin 2025/28**

(21) Application number: **23879546.2**

(22) Date of filing: **22.09.2023**

(51) International Patent Classification (IPC):
**H01S 5/183** (2006.01)    **H01S 5/343** (2006.01)

(52) Cooperative Patent Classification (CPC):
**H01S 5/183; H01S 5/343**

(86) International application number:
**PCT/JP2023/034557**

(87) International publication number:
**WO 2024/084898 (25.04.2024 Gazette 2024/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.10.2022 JP 2022166115**

(71) Applicant: **Stanley Electric Co. Ltd.
Tokyo 153-8636 (JP)**

(72) Inventor: **KURAMOTO, Masaru
Tokyo 153-8636 (JP)**

(74) Representative: **Wimmer, Hubert
Wagner & Geyer Partnerschaft mbB
Patent- und Rechtsanwälte
Gewürzmühlstrasse 5
80538 München (DE)**

(54) **VERTICAL CAVITY LIGHT EMITTING ELEMENT**

(57)    Provided is a vertical cavity light emitting element having a low threshold current density, high light emission efficiency, and an improved lifespan. A vertical cavity surface emitting laser 10 includes a semiconductor DBR 12, an n-type semiconductor layer 13 formed on the semiconductor DBR 12, an active layer 15 provided on the n-type semiconductor layer 13, an intermediate layer 16 provided on the active layer 15, an electron blocking layer 17 provided on the intermediate layer 16 and containing Al in a composition, a p-type semiconductor layer 18 provided on the electron blocking layer 17, containing Al in a composition, and doped with an impurity, and a dielectric DBR 25 provided on the p-type semiconductor layer 18. The electron blocking layer 17 is a composition gradient layer in which an Al composition decreases in a direction away from the active layer 15, and an impurity concentration of the impurity has a peak in the electron blocking layer 17 and decreases in a direction toward the active layer 15 from the peak.

FIG.3

Description

Technical Field

The present invention relates to a vertical cavity light emitting element.

Background Art

In a related art, a vertical cavity light emitting element such as a vertical cavity surface emitting laser (VCSEL) having a structure in which light is resonated perpendicularly to a substrate surface to emit the light in a direction perpendicular to the substrate surface is known.

In the vertical cavity light emitting element, a high carrier density is required in an active layer as compared with a light emitting diode (LED) or the like. Various developments have been made to improve the injection efficiency of the vertical cavity light emitting element and to improve the optical output.

Patent Literature 1 discloses a nitride semiconductor laser diode having a composition gradient region including a region formed of AlGaN in which an Al composition ratio continuously increases in a direction away from an active layer in order to increase light emission efficiency of a laser diode.

In addition, Patent Literature 2 discloses an ultraviolet light emitting element having a nitride semiconductor that utilizes a polarization doping effect of a composition gradient layer in which an Al composition y decreases in a direction away from a substrate.

Patent Literature 3 discloses a semiconductor wafer having an electron blocking layer containing Mg as a p-type dopant.

Patent Literature 4 discloses a nitride semiconductor light emitting element having a composition gradient layer in which a composition gradient is provided such that an Al composition value decreases toward a side on which a sum of the spontaneous polarization and the piezoelectric polarization is negative, in order to improve hole injection efficiency into an active layer.

Citation List

Patent Literatures

Patent Literature 1: Japanese Patent Application Laid-Open No. 2021-184456
Patent Literature 2: Japanese Patent Application Laid-Open No. 2022-041738
Patent Literature 3: Japanese Patent No. 6830098
Patent Literature 4: Japanese Patent No. 6192378

Summary of Invention

Technical problem

The vertical cavity light emitting element in the related art has objects of further reduction of a threshold current and improvement of the light emission efficiency and the lifespan.

An object of the present invention is to provide a vertical cavity light emitting element that has a low threshold current density and high light emission efficiency and that has an improved lifespan.

Solution to Problem

A first aspect of the present invention relates to a vertical cavity light emitting element including: a first reflective mirror; an n-type semiconductor layer formed on the first reflective mirror; an active layer provided on the n-type semiconductor layer; an intermediate layer provided on the active layer; an electron blocking layer provided on the intermediate layer and containing Al in a composition; a p-type semiconductor layer provided on the electron blocking layer and doped with an impurity; and a second reflective mirror provided on the p-type semiconductor layer, in which the electron blocking layer is a composition gradient layer in which an Al composition decreases in a direction away from the active layer, and an impurity concentration of the impurity has a peak in the electron blocking layer and decreases in a direction toward the active layer from the peak.

Brief Description of Drawings

FIG. 1 is a cross-sectional view schematically illustrating a structure of a vertical cavity surface emitting laser according to a first embodiment of the present invention.
FIG. 2 is a diagram schematically illustrating a band structure of a conduction band of the vertical cavity surface emitting laser.
FIG. 3 is a diagram schematically illustrating band structures of conduction bands of an electron blocking layer (EBL) and the vicinity thereof in an enlarged manner.
FIG. 4 is a diagram illustrating a SIMS analysis profile of a semiconductor layer of the vertical cavity surface emitting laser.
FIG. 5 is a band diagram schematically illustrating a band structure of a pn junction structure consisting of an n-type semiconductor, an active layer (light emitting layer), and a p-type semiconductor.
FIG. 6A is a diagram conceptually illustrating a hole generated by piezoelectric polarization.
FIG. 6B is a diagram illustrating a band diagram of the electron blocking layer (EBL).
FIG. 6C is a graph illustrating a simulation result of a generated hole concentration with respect to a distance z from an interface of the electron blocking layer on an active layer side illustrated in FIG. 6B.

FIG. 7 is a graph in which a hole concentration (cm$^{-3}$) generated in the electron blocking layer is plotted with respect to an average composition gradient CS (%/nm) of Al in the electron blocking layer.

FIG. 8A is a diagram illustrating another example of an Al composition profile of the electron blocking layer.

FIG. 8B is a diagram illustrating another example of the Al composition profile of the electron blocking layer.

FIG. 8C is a diagram illustrating still another example of the Al composition profile of the electron blocking layer.

FIG. 9 is a diagram schematically illustrating a standing wave of an electric field strength in semiconductor layers from an active layer to a dielectric DBR in a vertical cavity surface emitting laser of Example 1 (Ex. 1).

FIG. 10 is a graph illustrating element characteristics (optical output-current density characteristics) of a vertical cavity surface emitting laser of Example 2 and vertical cavity surface emitting lasers of Comparative Example 1 and Comparative Example 2.

FIG. 11 is a cross-sectional view schematically illustrating a structure of a vertical cavity surface emitting laser according to a second embodiment.

Description of Embodiments

Hereinafter, preferred embodiments of the present invention will be described, but these embodiments may be modified as appropriate and combined. In addition, in the following description and the accompanying drawings, substantially the same or equivalent parts will be denoted by the same reference numerals.

[First Embodiment]

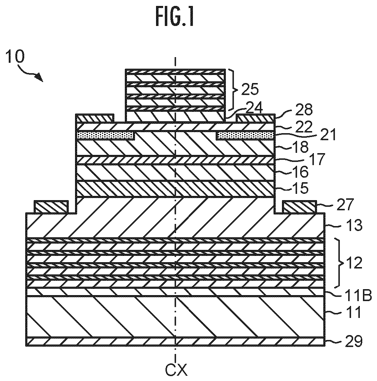

FIG. 1 is a cross-sectional view schematically illustrating a structure of a vertical cavity surface emitting laser 10 according to a first embodiment of the present invention. In the present embodiment, the vertical cavity surface emitting laser 10 is a nitride surface emitting laser consisting of III-V nitride-based semiconductor layers.

The vertical cavity surface emitting laser 10 is formed by crystal-growing a semiconductor distributed Bragg reflector (DBR) 12, an n-type semiconductor layer 13, an active layer 15 consisting of multiple quantum wells, an intermediate layer 16, an electron blocking layer (EBL) 17, and a p-type semiconductor layer 18 in this order on a substrate 11.

The substrate 11 is a GaN substrate. The substrate 11 is a +C surface GaN substrate that is inclined by 0.5° in an M surface direction and 0 ± 0.1° in an A surface direction from a C surface.

The crystal growth of the semiconductor layer is performed by metalorganic vapor-phase epitaxy (MOVPE) method. A base GaN layer 11B having a layer thickness of approximately 1 μm is grown on the substrate 11, and the semiconductor DBR 12, which is a distributed Bragg reflector, is formed on the base GaN layer 11B.

The semiconductor DBR 12 (first reflective mirror) is formed by laminating 42 pairs of n-type GaN films and AlInN films. Each semiconductor film of the semiconductor DBR 12 has a film thickness that is $\lambda/4n$ (n is a refractive index of each semiconductor film) of a light emission wavelength $\lambda$ of the active layer 15.

On the semiconductor DBR 12, the n-type semiconductor layer 13 (layer thickness: 350 nm), which is an n-type GaN layer doped with Si (silicon), is grown.

A blocking layer (barrier layer) 15B and a quantum well layer 15W are alternately formed on the n-type semiconductor layer 13, to form the active layer 15 having four quantum well layers (well layers) 15W. The barrier layer 15B consists of GaInN (layer thickness: 3 nm), and the well layer 15W consists of GaN (layer thickness: 4 nm). The compositions and the layer thicknesses of the barrier layer 15B and the well layer 15W can be selected as appropriate depending on a desired light emission wavelength, light emission characteristics, and the like.

An undoped GaN is grown on a final well layer 15WL, which is a final layer of the active layer 15, as the intermediate layer (LB) 16, which is a final barrier layer, to a layer thickness of 120 nm. That is, the intermediate layer 16 is a layer between the active layer 15 and the electron blocking layer (EBL) 17.

Next, the electron blocking layer (EBL) 17 consisting of $Al_xGa_{1-x}N$ (Al composition: x) doped with magnesium (Mg) as an impurity is grown.

Subsequently, a p-GaN layer doped with Mg as the p-type semiconductor layer 18 is grown to a thickness of 83 nm on the electron blocking layer 17 (p-AlGaN).

An outer peripheral portion of a wafer grown as described above is etched to reach the inside of the n-type semiconductor layer 13, to form a columnar mesa structure.

The outer peripheral portion of the p-type semiconductor layer 18, which is the uppermost semiconductor layer of the mesa structure, is etched to a depth of about 20 nm by dry etching to form a recess portion, thereby forming the p-type semiconductor layer 18 having a columnar mesa protrusion portion.

An insulating film ($SiO_2$) 21 having a thickness of 20 nm for a lateral current and light confinement is deposited in the recess portion of the p-type semiconductor layer 18 formed by etching. As a result, the recess portion of the p-type semiconductor layer 18 is flattened, a current confinement structure is formed, and a columnar (center axis: CX) current injection region is formed.

Next, an ITO (indium tin oxide) film having a thickness of 20 nm is formed as a transparent conductive film 22 on the p-type semiconductor layer 18 and the insulating film 21.

Subsequently, a dielectric ($Nb_2O_5$) is formed into a film as a spacer layer 24 to a thickness of 38 nm. The spacer layer 24 functions as a phase adjusting layer.

Further, the dielectric DBR 25 (second reflective mirror) is formed on the spacer layer 24. The dielectric DBR 25 consists of 10.5 pairs of $SiO_2$ (11 layers) and $Nb_2O_5$ (10 layers). It is preferable that the dielectric DBR 25 is formed coaxially with the columnar mesa of the p-type semiconductor layer 18.

Next, an n-electrode 27 is formed on the recess portion of the outer peripheral portion of the n-type semiconductor layer 13, and a p-electrode 28 is formed on the transparent conductive film 22. In addition, a rear surface of the substrate 11 is polished, and an antireflection (AR) coating 29 (antireflection film) consisting of two layers of $Nb_2O_5/SiO_2$ is formed. As described above, the formation of the vertical cavity surface emitting laser 10 is completed.

The above-described composition and layer thickness of the intermediate layer (LB) 16 are merely examples. That is, although the intermediate layer 16 has been described as the GaN layer, a nitride semiconductor layer having different compositions, such as InGaN, Al-GaN, InAlGaN, or the like, may be used. In addition, the intermediate layer 16 is an undoped layer, but a dopant diffused from the electron blocking layer 17 or the p-type semiconductor layer 18 may be mixed.

Further, the layer thickness of the electron blocking layer 17 is merely an example. The electron blocking layer 17 may have, for example, a layer thickness of 3 to 30 nm. In addition, the electron blocking layer 17 consists of a nitride semiconductor containing Al in a composition. Further, the electron blocking layer 17 is formed as a composition gradient layer in which an Al composition changes in a layer thickness direction. The details will be described below.

The electron blocking layer 17 has been described as the p-type semiconductor layer (p-AlGaN), but may be a p-type semiconductor layer containing Al in a composition, which is grown as an i-layer and in which the impurity (Mg) diffused from the p-type semiconductor layer 18 is mixed.

In addition, although a case has been described in which the active layer 15 is a quantum well active layer and has four quantum well layers 15W, the active layer 15 need only have at least one quantum well layer. In addition, the active layer 15 is not limited to the quantum well active layer. It is possible to also use an active layer having a so-called bulk structure.

Further, the p-type semiconductor layer 18 may be composed of a plurality of semiconductor layers including layers having different compositions and/or doping concentrations, and an undoped layer. Similarly, the n-type semiconductor layer 13 may be composed of a plurality of semiconductor layers.

Although a case has been described in which the dielectric DBR 25 consists of the $SiO_2$ film and the $Nb_2O_5$ film, the dielectric DBR 25 may be composed of dielectric films having different refractive indices in other combinations. Further, the dielectric DBR 25 may be composed of the semiconductor DBR composed of semiconductor films having different refractive indices.

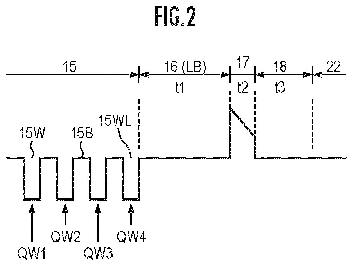

FIG. 2 is a diagram schematically illustrating a band structure of a conduction band of the vertical cavity surface emitting laser 10. The band structure from the active layer 15 to the p-type semiconductor layer 18 is illustrated.

The active layer 15 consists of four well layers 15W QW1 to QW4 and the barrier layer 15B provided therebetween. The quantum well layer QW4, which is adjacent to the intermediate layer (LB) 16, is the final well layer 15WL.

The intermediate layer 16 has a layer thickness t1, the electron blocking layer 17 has a layer thickness t2, and the p-type semiconductor layer 18 has a layer thickness t3.

[Al Composition of Electron Blocking Layer]

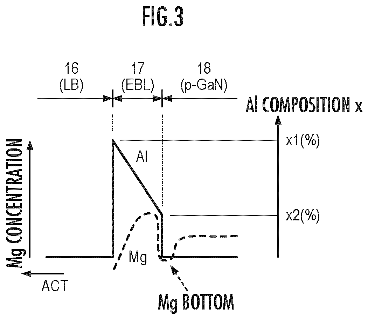

FIG. 3 is a diagram schematically illustrating band structures of conduction bands of an electron blocking layer 17 (EBL) and the vicinity thereof in an enlarged manner. In addition, as in FIG. 2, a left side of the drawing is the active layer 15 (ACT) side.

As illustrated in FIG. 3, the electron blocking layer 17 is formed as an Al composition gradient layer in which the Al composition decreases in a direction away from the active layer 15 (ACT). Specifically, the Al composition (x) of the electron blocking layer 17 decreases linearly from x1 (%) to x2 (%).

In the present specification, the "composition gradient" of the Al composition (x) is not limited to a case in which the Al composition decreases linearly or monotonically. It is sufficient that the Al composition (x1) at an interface (interface with the intermediate layer 16) on the active layer 15 side is the highest and the Al composition (x2) at an interface with the p-type semiconductor layer 18 is the lowest. Further, the composition (x) may include a portion in which the composition (x) is constant from the interface on the active layer 15 side to the interface with the p-type semiconductor layer 18.

In addition, FIG. 3 schematically illustrates a concentration profile (broken line) of Mg which is a p-dopant. As illustrated in the concentration profile of Mg, the Mg concentration decreases in a direction toward the active layer 15 from an interface between the intermediate layer 16 and the electron blocking layer 17, and has a peak in a vicinity of a terminal of the electron blocking layer 17 (interface with the p-type semiconductor layer 18). Here, the vicinity of the interface with the p-type semiconductor layer 18 refers to a position closer to the p-type semiconductor layer 18 than at least the center of the electron blocking layer 17.

In addition, the profile of the Mg concentration has a bottom on the p-type semiconductor layer 18 side with respect to the peak of the Mg concentration in the vicinity of the interface between the electron blocking layer 17 and the p-type semiconductor layer 18, that is, at a position corresponding to the interface. That is, the profile of the Mg concentration has a dip at the interface position, and a bottom of the dip is formed in the vicinity of the interface.

Such a Mg concentration profile is due to the provision of the electron blocking layer 17 (AlGaN layer) between the intermediate layer 16 (GaN layer) and the p-type semiconductor layer 18 (p-GaN layer).

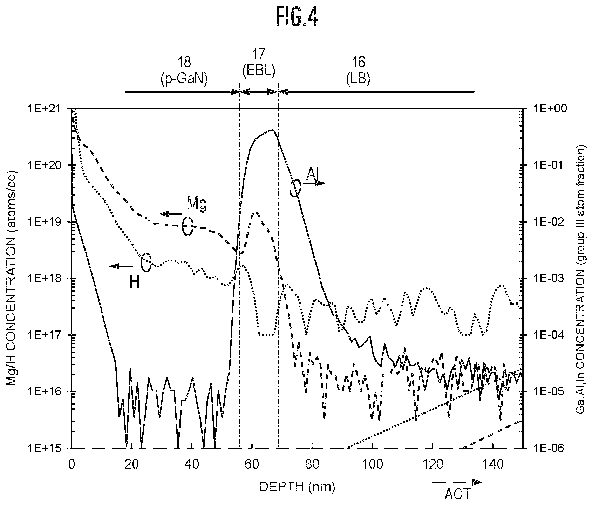

FIG. 4 illustrates a profile of the semiconductor layer of the vertical cavity surface emitting laser 10, which is analyzed by secondary ion mass spectrometry (SIMS). The analysis is carried out from the surface of the p-type semiconductor layer 18, and, in the drawing, a right direction is a depth direction and is a direction from the p-type semiconductor layer 18 to the active layer 15. That is, it should be noted that a positional relationship between the active layer 15 and the electron blocking layer 17 is opposite to that in FIGS. 2 and 3. That is, in FIG. 4, the direction away from the active layer 15 (ACT) is a left direction in the drawing.

As illustrated in FIG. 4, in the electron blocking layer 17, the Al composition of the electron blocking layer 17 has a peak in the vicinity of the intermediate layer 16 and decreases in the direction away from the active layer 15.

Meanwhile, the Mg concentration decreases in the direction toward the active layer 15 in the electron blocking layer 17. That is, the Mg concentration profile has a concentration gradient in an opposite direction to the composition gradient of Al.

That is, the electron blocking layer 17 has a composition gradient in which the Al composition is high on the active layer 15 side and is low on the p-type semiconductor layer 18 side, and the Mg concentration in the electron blocking layer 17 decreases in the direction toward the active layer 15.

Even in a case in which the impurity (Mg) diffuses from the p-type semiconductor layer 18 to the electron blocking layer 17, the Mg concentration in the electron blocking layer 17 exhibits the same profile as described above. That is, the Mg concentration reaches the bottom and decreases in the direction toward the active layer 15.

[Effective Barrier of Electron Blocking Layer, Mg Concentration, Hole Generation due to Piezoelectric Polarization]

Hereinafter, a relationship between the effective barrier of the electron blocking layer and the concentration of Mg which is a p-dopant, and the hole generation due to the piezoelectric polarization will be described.

In the related art, by increasing the Mg concentration of the electron blocking layer, the injection efficiency of carriers increases, and the efficiency of laser diodes (LDs) and vertical cavity surface emitting lasers (VCSELs) is improved.

However, in order to increase the lifespan of the vertical cavity surface emitting laser, it is necessary to reduce the steepness of the Mg concentration and to reduce the Mg concentration on the active layer side. On the other hand, there is a problem in that the external quantum efficiency is reduced in a case in which the Mg concentration on the active layer side is reduced.

In particular, in a semiconductor laser such as a VCSEL, since the driving current density and the electron and hole concentration in the light emitting layer are about two digits higher as compared with those of the LED, there is a problem in that, in a case in which the Mg concentration of the electron blocking layer is reduced, the effective barrier energy is reduced, and high-energy electrons leak to the p layer side, which results in a decrease in injection efficiency.

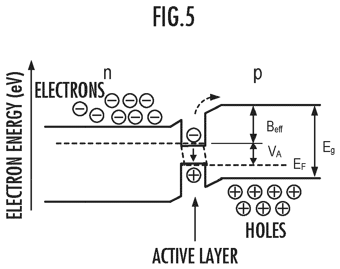

FIG. 5 is a band diagram schematically illustrating a band structure of a pn junction structure consisting of the n-type semiconductor, the active layer (light emitting layer), and the p-type semiconductor.

In a case in which the applied voltage to the pn junction is denoted by $V_A$, the Fermi level is denoted by $E_F$, and the band gap is denoted by $E_g$, the effective barrier height $B_{eff}$ that determines the injection efficiency of the carrier into the active layer is represented by $B_{eff} = E_g - V_A - E_F$.

The Fermi level $E_F$ changes in accordance with the Mg concentration. Specifically, in a case in which the Mg concentration (acceptor concentration) is reduced, the Fermi level $E_F$ increases, and the effective barrier height $B_{eff}$ decreases. In a case in which the effective barrier height $B_{eff}$ decreases, the blocking layer effect of the electron blocking layer decreases, and the injection efficiency of electrons decreases.

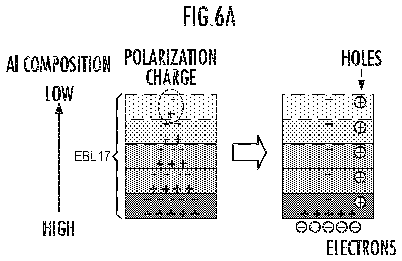

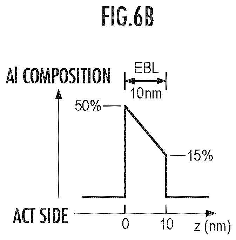

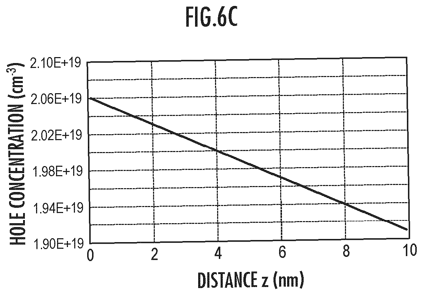

FIG. 6A is a diagram conceptually illustrating the hole generated by the piezoelectric polarization. In addition, FIG. 6B illustrates a band diagram of the electron blocking layer 17, and FIG. 6C is a graph illustrating a simulation result of the hole concentration with respect to a distance z (distance in the lamination direction) from the interface of the electron blocking layer 17 illustrated in FIG. 6B on the active layer 15 side.

The piezoelectric polarization occurs in a crystal system (for example, a hexagonal crystal) having an asymmetric crystal structure. The following simulation is performed in a case in which the electron blocking layer consisting of AlGaN is formed on the +C surface of the GaN substrate.

As illustrated in FIG. 6A, a polarization charge is generated by piezoelectric polarization in the electron blocking layer 17 (AlGaN) of the Al gradient composition (left side of the drawing). The polarization is larger as the Al composition is higher. The holes are generated in the electron blocking layer 17 due to the polarization charge (right drawing).

As illustrated in FIG. 6B, the Al composition of the electron blocking layer 17 on the active layer 15 side is 50%, and the Al composition of the electron blocking layer 17 on the p-GaN layer 18 side is 15%. In addition, the electron blocking layer 17 has a layer thickness of 10 nm.

As illustrated in FIG. 6C, it can be seen that holes having a concentration of $1.9 \times 10^{19}$ cm$^{-3}$ to $2.0 \times 10^{19}$ cm$^{-3}$ are generated in the electron blocking layer 17.

That is, it is found that, since a high hole concentration can be obtained even in a case in which the doping amount of Mg is reduced, the effective barrier height can be secured without the increase in the Fermi level. That is, it is possible to maintain high injection efficiency while reducing the doping concentration of Mg.

Again, with reference to the SIMS data of FIG. 4, the Mg concentration has a bottom (Mg concentration: about $3 \times 10^{18}$ cm$^{-3}$) in the vicinity of the interface between the electron blocking layer 17 and the p-type semiconductor layer 18 (p-GaN layer).

By forming the bottom of the Mg concentration between the electron blocking layer 17 and the p-type semiconductor layer 18 (p-GaN layer), the total amount of the Mg concentration can be reduced, and the element lifespan can be increased.

From the viewpoint of element lifespan, the Mg concentration at the interface between the electron blocking layer 17 and the intermediate layer 16 is preferably less than $1.0 \times 10^{19}$ cm$^{-3}$ and preferably less than $5.0 \times 10^{18}$ cm$^{-3}$.

In addition, as illustrated in FIG. 4, a peak of hydrogen (H) is formed at a position corresponding to the bottom of the Mg concentration. That is, hydrogen is trapped by a portion having the bottom of the Mg concentration, and the peak of hydrogen is formed.

Therefore, the entry of hydrogen into the active layer 15 is suppressed, and the optical output characteristics such as the voltage-current characteristics of the vertical cavity surface emitting laser 10 are stabilized.

[Al Composition Profile of Electron Blocking Layer]

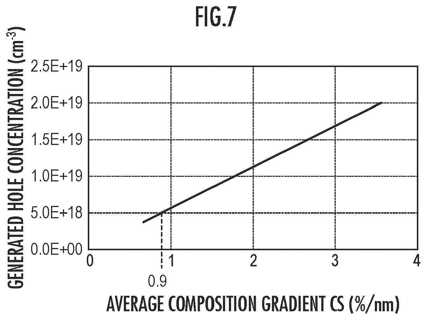

FIG. 7 is a graph in which the hole concentration (cm$^{-3}$) generated in the electron blocking layer 17 is plotted with respect to the average composition gradient CS (%/nm) of Al in the electron blocking layer 17.

Since the generated hole concentration of $5.0 \times 10^{18}$ cm$^{-3}$ or more is required to maintain the injection efficiency of the vertical cavity surface emitting laser 10, the average composition gradient CS is preferably 0.9 (%/nm) or more from the graph of FIG. 7.

The average composition gradient CS (that is, CS = (x1 - x2)/t2) is preferably 0.9 (%/nm) or more, except for a case in which the Al composition is linearly inclined.

The Al composition profile of the electron blocking layer 17 is not limited to the above-described linear composition gradient. It is sufficient that the Al composition of the electron blocking layer 17 is the highest on the active layer 15 side of the electron blocking layer 17, and is the lowest on the p-type semiconductor layer 18 side.

On the other hand, in a case in which the product (nm) of the average Al composition (%) and the layer thickness of the electron blocking layer 17 is equal to or higher than a certain value, the electron blocking layer 17 is destroyed due to stress, and the cracks are generated. Specifically, in a case in which the product of the average Al composition (%) and the layer thickness t2 (nm) exceeds 700 (%·nm), the cracks may occur. For example, in a case in which the average Al composition of the electron blocking layer 17 is 70% and the layer thickness t2 is 10 nm, the cracks may occur. Therefore, the product of the average Al composition (%) in the electron blocking layer 17 and the layer thickness t2 (nm) need only be lower than 700 (%·nm).

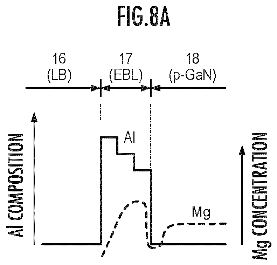

For example, as illustrated in FIG. 8A, the electron blocking layer 17 may have an Al composition profile in which the Al composition decreases in a stepwise manner from the active layer 15 side to the p-type semiconductor layer 18 side.

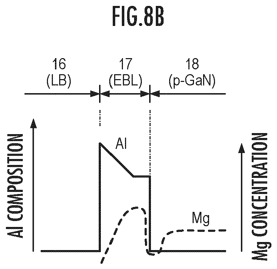

Alternatively, as illustrated in FIG. 8B, the electron blocking layer 17 may have an Al composition profile consisting of an inclined composition portion in which the Al composition decreases from the active layer 15 side and a composition constant portion in which the Al composition is constant from the inclined composition portion to the p-type semiconductor layer 18.

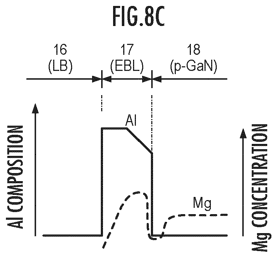

Alternatively, as illustrated in FIG. 8C, the electron blocking layer 17 may have an Al composition profile consisting of a composition constant portion in which the Al composition is constant from the active layer 15 side and an inclined composition portion in which the Al composition decreases from the composition constant portion to the p-type semiconductor layer 18.

Alternatively, the electron blocking layer 17 may have an Al composition profile in which these Al composition profiles are combined.

[High Efficiency of Carrier Injection into Multiple Quantum Well Active Layer]

As described above in detail, the carrier injection efficiency and the reliability (element lifespan) which are the objects of the present application are improved by the vertical cavity surface emitting laser 10 formed to satisfy the above-described Al composition profile and the concentration of the impurity (Mg) described above.

Further, in a case in which a multiple quantum well (MQW) structure consisting of a plurality of quantum well layers is used in the active layer, it is possible to achieve higher carrier injection efficiency and a longer lifespan by further satisfying the conditions described below.

First, the first interface between a high reflective mirror such as a distributed Bragg reflector (DBR), a diffraction grating, or the like and the inside of the cavity is defined as phase 0" (reference).

Using a refractive index ni, a layer thickness $t_i$, and a light emission wavelength $\lambda$ of each layer in the cavity, the total phase information of the standing wave in the cavity is represented by the following expression (1).

$$\sum_{i=1}^{n} \frac{t_i}{\left(\dfrac{\lambda}{n_i}\right)} \quad \cdots (1)$$

The synthetic information of the standing waves at a predetermined position inside the layer is considered by replacing the thickness from the interface with another layer on the cavity side to a predetermined position with $t_i$.

A first condition is that the number $N_{AN}$ of anti-nodes AN and the number $N_{ND}$ of nodes ND of the standing wave SW included in the p-type semiconductor layer 18 and the electron blocking layer 17 in a p region are each 0 or 1 ($N_{AN} = 0$ or $N_{AN} = 1$, $N_{ND} = 0$ or $N_{ND} = 1$).

In a case in which the layer thicknesses of the transparent conductive film 22 (ITO), the p-type semiconductor layer 18, and the electron blocking layer 17 are denoted by $H_{ITO}$, $H_{GaN}$, and $H_{EB}$, the refractive indices are denoted by $n_{ITO}$, $n_{GaN}$, and $n_{EB}$, and the wavelength is denoted by $\lambda$, it is preferable that the following expression (2) is satisfied.

$$\frac{H_{ITO}}{2\left(\dfrac{\lambda}{n_{ITO}}\right)} + \frac{H_{GaN}}{\left(\dfrac{\lambda}{n_{GaN}}\right)} + \frac{H_{EB}}{\left(\dfrac{\lambda}{n_{EB}}\right)} \leq 0.6 \quad \cdots (2)$$

Further, a second condition is that the number of nodes ND and the number of anti-nodes AN of the standing wave SW included in the intermediate layer 16 are each one or more ($N_{ND} \geq 1$ and $N_{AN} \geq 1$).

The number $N_{ND}$ of nodes ND and the number $N_{AN}$ of anti-nodes AN of the standing wave SW can be obtained from the number of nodes in which the phase is $k\pi$ ($k = 1, 2, ...$) and the number of anti-nodes in which the phase is $(2l - 1)\pi/2$ ($l = 1, 2, ...$) in the p region and the intermediate layer 16 by calculating the total phase in the p region and the intermediate layer 16 using the above-described expression (1).

Expression (1) = $k/2$($k = 1, 2,...$) indicates a position at which the standing wave becomes the anti-node AN, and Expression (1) = $(2l - 1)/4$($l = 1, 2,...$) indicates a position at which the standing wave becomes the node ND. That is, the $N_{ND}$ and $N_{AN}$ in the p-type semiconductor layer 18, the electron blocking layer 17, and the intermediate layer 16 are obtained by counting how many of the positions of the anti-nodes AN and the nodes ND are included within a lamination range of each layer.

In addition, in a case in which the layer thicknesses of the intermediate layer 16 and the active layer 15 are respectively denoted by $H_{fb}$ and $H_{qw}$, it is preferable that the following expression (3) is satisfied. Here,

$n_{fb}$ is a refractive index of the intermediate layer 16, and $n_{qw}$ is an equivalent refractive index of the active layer 15.

$$\frac{H_{qw}}{2\left(\dfrac{\lambda}{n_{qw}}\right)} + \frac{H_{fb}}{\left(\dfrac{\lambda}{n_{fb}}\right)} \geq 0.4 \quad \cdots (3)$$

$$\text{Here,} \quad n_{qw} = \frac{\sum n_i \times H_i}{\sum H_i}$$

Further, it is preferable that (i) the intermediate layer 16 has a layer thickness of $\lambda/4$ or more. That is, it is preferable that the following expression (4) is satisfied.

$$\frac{H_{fb}}{\left(\dfrac{\lambda}{n_{fb}}\right)} \geq \frac{1}{4} \quad \cdots (4)$$

In addition, it is preferable that (ii) the number of nodes ND included in the intermediate layer 16 is two or more ($N_{ND} \geq 2$) and the number of nodes AN is one or more ($N_{AN} \geq 1$). In a case in which (i) and (ii) are satisfied, it is preferable that the following expression (5) is further satisfied.

$$\frac{H_{fb}}{\left(\dfrac{\lambda}{n_{fb}}\right)} \geq \frac{3}{8} \quad \cdots (5)$$

Further, it is preferable that the layer thickness of the active layer 15 is $\lambda/8$ or less, that is, the following expression (6) is satisfied. In this case, it is possible to reduce light confinement loss in the active layer 15.

$$\frac{H_{qw}}{2\left(\dfrac{\lambda}{n_{qw}}\right)} \leq \frac{1}{8} \quad \cdots (6)$$

With the above-described configuration, the electric field strength of light from the p-type semiconductor layer 18 to the electron blocking layer 17 increases. In addition, the presence of the anti-node AN with a high electric field strength of light and at least one node ND in the intermediate layer 16 excites the active layer 15 to the extent that a large optical gain can be obtained.

Further, in a case in which the internal light intensity increases due to the semiconductor DBR 12 and the dielectric DBR 25, which are high reflective mirrors, electrons and holes in the intermediate layer 16 are excited by internal light, holes accumulated at the interface between the electron blocking layer 17 and the p-type semiconductor layer 18 are extracted into the active layer 15, and switching-like hole injection into the active layer 15 occurs.

As a result, the uniformity of carriers (electrons and holes) in each of the plurality of well layers 15W of the active layer 15 is improved, and an efficient surface emitting laser can be realized.

[Consideration of Mechanism of Characteristic Improvement]

With the above-described configuration, the uniformity of carriers (electrons and holes) in each of the well layers 15W of the active layer 15 is improved, and an efficient surface emitting laser can be realized. The mechanism by which characteristics such as efficiency or the like can be improved in this way will be considered.

It is considered that the mechanism of the Characteristic improvement is related to the switching injection of holes in order to eliminate carrier non-uniformity in the multiple quantum well. This surface emitting laser is designed such that the anti-nodes of the standing wave are aligned with the center of the active layer (multiple quantum well). That is, by disposing the active layer in which the electric field of light is large, the interaction between light and electron-hole recombination increases.

Therefore, the intermediate layer 16, which is adjacent to the active layer 15, is in a direction in which the electric field strength of light decreases. However, as mentioned above, by disposing the intermediate layer 16 in which the anti-node of the standing wave different from the active layer is located or to include the vicinity of the anti-node, it is presumed that the light intensity in this layer increases significantly in the vicinity of a threshold of the laser oscillation current and carriers (electrons and holes) are generated, which has the effect of pulling in the holes on the p-type semiconductor layer 18 side of the electron blocking layer 17 all at once. This pull-in tends to occur in a case in which the electric field gradient in the p region is high.

It is considered that this effect is due to the increase in the concentration of holes accumulated on the p-type semiconductor layer 18 side and the increase in the electric field gradient of the electron blocking layer 17. It is considered that the pull-in of the switching-type hole improves the uniformity of the carrier distribution of the multiple quantum well and reduces the internal loss. Therefore, in some cases, due to the laser oscillation, characteristics that cannot be seen in the characteristics of the normal surface emitting laser (VCSEL), such as minimum values of the differential resistance and drive current in the vicinity of the threshold ($dR/dI = 0$, $d^2V/dI^2 = 0$), may be obtained. Therefore, the important factors are the position of the anti-node of the intermediate layer 16, the thinning of the p-layer (electron blocking layer 17 and p-type semiconductor layer 18), the strong feedback of light in the vertical direction by a high reflective mirror, and the light intensity such that there is the optical gain.

[Example 1]

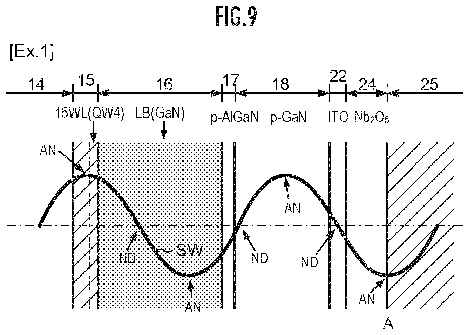

FIG. 9 is a diagram schematically illustrating the standing wave SW of the electric field strength of light emitted from the active layer 15 in the semiconductor layer from the active layer 15 to the dielectric DBR 25 in the vertical cavity surface emitting laser 10 of Example 1 (Ex. 1) of the present embodiment.

As described above, the vertical cavity surface emitting laser 10 of Example 1 (Ex. 1) is provided with the undoped GaN layer having a layer thickness of 120 nm as the intermediate layer (LB) 16.

In addition, the electron blocking layer 17 has a layer thickness of 10 nm and has a composition gradient in which the Al composition is reduced from 50% to 15% in the direction away from the active layer 15.

Further, a p-GaN layer having a layer thickness of 83 nm is provided on the electron blocking layer 17 as the p-type semiconductor layer 18.

In Example 1, the electron blocking layer 17 is doped with Mg at a doping concentration of $1.0 \times 10^{18}$ to $1.0 \times 10^{19}$ cm$^3$, and the p-type semiconductor layer 18 is doped with Mg at a doping concentration of $1.0 \times 10^{18}$ cm$^3$ or more. However, the doping concentration is not limited thereto, and can be set as appropriate in accordance with the composition, the layer thickness, and the like of the p-side semiconductor layer such as the intermediate layer 16, the electron blocking layer 17, and the p-type semiconductor layer 18.

In Example 1 (Ex. 1), there are one node ND and one anti-node AN of the standing wave SW in the intermediate layer 16. That is, in a case in which the number of nodes ND is denoted by $N_{ND}$ and the number of anti-nodes AN is denoted by $N_{AN}$, $N_{ND} = 1$ and $N_{AN} = 1$. As illustrated in FIG. 9, a high reflective mirror interface A formed by the dielectric DBR 25 is located at the anti-node AN of the standing wave SW.

In the electron blocking layer (EBL) 17 and the p-type semiconductor layer (p-GaN) 18 which are the p region, one node ND and one anti-node AN of the standing wave SW are present ($N_{ND} = 1$, $N_{AN} = 1$). Further, it is preferable that one node ND of the standing wave SW is present in the transparent conductive film (ITO) 22 ($N_{ND} = 1$).

With such a configuration, the electric field strength from the p-type semiconductor layer 18 to the electron blocking layer 17 increases. In addition, the presence of the anti-node with a high electric field strength of light and at least one node in the intermediate layer 16 excites the active layer 15 to the extent that a large optical gain can be obtained.

Further, in a case in which the internal light intensity increases due to the semiconductor DBR 12 and the dielectric DBR 25, which are high reflective mirrors, electrons and holes in the intermediate layer 16 are excited by internal light, holes accumulated at the interface between the electron blocking layer 17 and the p-type semiconductor layer 18 are extracted into the active layer 15, and switching-like hole injection into the active layer 15 occurs.

This configuration promotes the uniformity of the carrier concentration between the multiple quantum wells, and the internal loss, the external differential quantum efficiency, and the slope efficiency are improved.

That is, it is possible to realize a surface emitting laser with improved uniformity of carriers (electrons and holes) in the plurality of well layers 15W and high efficiency.

In addition, it is possible to provide a vertical cavity light emitting element in which the reliability (lifespan) of the element is improved and the operating current can be reduced.

[Element Characteristics: Effect of Reducing Mg Concentration]

A vertical cavity surface emitting laser 10 of Example 2 of the present embodiment, and vertical cavity surface emitting lasers of Comparative Examples 1 and 2 are produced, and the element characteristics are evaluated. The evaluation result will be described below.

[Example 2]

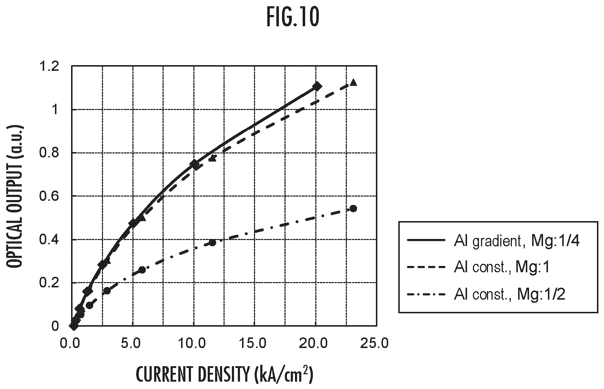

FIG. 10 is a graph illustrating element characteristics (optical output-current density characteristics) of the vertical cavity surface emitting laser 10 of Example 2 (Ex. 2), the vertical cavity surface emitting laser of Comparative Example 1 (Cmp. 1), and the vertical cavity surface emitting laser of Comparative Example 2 (Cmp. 2).

In Example 2 (Ex. 2), the vertical cavity surface emitting laser 10 includes the electron blocking layer 17 having a composition gradient in which the Al composition is reduced from 50% to 15% in the direction away from the active layer 15 with a layer thickness of 10 nm (see FIG. 6B).

The doping concentration of Mg to the electron blocking layer 17 is $0.25 \times 10^{19}$ cm$^{-3}$, which is 1/4 of the concentration of Comparative Example 1 described below.

The vertical cavity surface emitting laser of Comparative Example 1 (Cmp. 1) has the same layer thickness (10 nm) of the electron blocking layer as in Example 2. Comparative Example 1 is different from Example 2 in that the electron blocking layer has a constant Al composition (Al composition: 30%). Further, the doping concentration of Mg is $1.0 \times 10^{19}$ cm$^{-3}$.

The vertical cavity surface emitting laser of Comparative Example 2 (Cmp. 2) is different from Comparative Example 1 in that the doping concentration of Mg is a concentration ($0.5 \times 10^{19}$ cm$^{-3}$) which is 1/2 of the doping concentration of Comparative Example 1 (Cmp. 1). Other points are the same as those of the vertical cavity surface emitting laser of Comparative Example 1.

The optical output characteristics of the vertical cavity surface emitting laser of Comparative Example 1 (Cmp. 1) having the electron blocking layer in the related art are illustrated by a broken line. In Comparative Example 2, it is confirmed that the doping concentration of Mg in the electron blocking layer is reduced to 1/2 of that in Comparative Example 1, but the optical output is significantly reduced as compared with that in Comparative Example 1.

On the other hand, in Example 2 (Ex. 2) having the Al composition gradient electron blocking layer, it is confirmed that even in a case in which the doping concentration of Mg is reduced to 1/4, the optical output characteristics exceeding those of Comparative Example 1 are obtained, and high light emission efficiency is obtained.

That is, with the vertical cavity surface emitting laser 10 of Example 2, it is confirmed that the doping concentration of Mg can be significantly reduced and high light emission efficiency can be obtained.

In addition, the electron blocking layer 17 having the Al composition gradient can maintain high injection efficiency while reducing the doping concentration of Mg.

Therefore, it is possible to provide a vertical cavity light emitting element in which the operating current can be reduced and the reliability (lifespan) of the element is improved.

[Example 3]

In a vertical cavity surface emitting laser 10 of Example 3 (Ex. 3), the layer thickness of the intermediate layer 16 is 220 nm, which is thicker than 120 nm of Example 1.

Further, the layer thickness of the p region (total layer thickness of the electron blocking layer 17 and the p-type semiconductor layer 18) is 101 nm (20 + 81 nm), which is thicker than 93 nm (10 + 83 nm) in Example 1.

In addition, the electron blocking layer 17 has a layer thickness of 20 nm and has a composition gradient in which the Al composition is reduced from 50% to 15% in the direction away from the active layer 15.

The configuration other than the above-described configuration is the same as that of Example 2.

In Example 3, in order to reflect that the intermediate layer 16 is thick, two nodes ND and two anti-nodes AN are present in the intermediate layer 16 ($N_{ND}$ = 2, $N_{AN}$ = 2). In addition, in the p region (electron blocking layer 17 and p-type semiconductor layer 18), one node ND and one anti-node AN are present ($N_{ND}$ = 1, $N_{AN}$ = 1).

Therefore, since the above-described first and second conditions are satisfied, it is possible to eliminate the decrease in the efficiency of the surface emitting laser due to the carrier non-uniformity between the well layers of the quantum well active layer, and to provide a high-efficiency surface emitting laser.

As in the present example, since the intermediate layer 16 can be made thick to satisfy the first and second conditions, it is possible to suppress the deterioration in element characteristics and lifespan due to migration of the dopant (Mg or the like).

In addition, the electron blocking layer 17 having the Al composition gradient can maintain high injection efficiency while reducing the doping concentration of Mg.

Therefore, it is possible to provide the vertical cavity light emitting element in which the operating current can be reduced and the reliability (lifespan) of the element is improved.

[Second Embodiment]

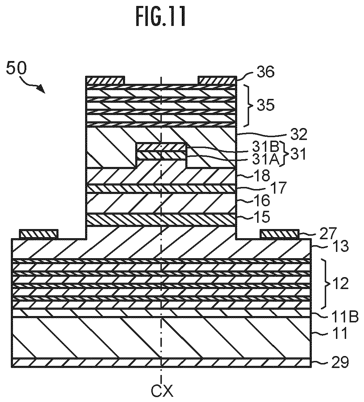

FIG. 11 is a cross-sectional view schematically illustrating a structure of a vertical cavity surface emitting laser 50 according to a second embodiment of the present invention. The vertical cavity surface emitting laser 50 according to the present embodiment has a tunnel junction as a current confinement structure.

The vertical cavity surface emitting laser 50 is a nitride surface emitting laser having the same configuration as the vertical cavity surface emitting laser 10 according to the first embodiment described above, except that the vertical cavity surface emitting laser 50 has a tunnel junction layer 31.

That is, the electron blocking layer 17 has a composition gradient in which the Al composition on the active layer 15 side is higher than that on the p-type semiconductor layer 18 side, and has a concentration profile in which the Mg concentration in the electron blocking layer 17 decreases in the direction toward the active layer 15.

More specifically, the vertical cavity surface emitting laser 50 is formed by crystal-growing the semiconductor DBR 12, the n-type semiconductor layer 13, the active layer 15 consisting of multiple quantum wells, the final barrier layer 16, the electron blocking layer (EBL) 17, and the p-type semiconductor layer 18 in this order on the substrate 11. In addition, the composition, the layer thickness, the impurity concentration, and the like of each semiconductor layer are also the same as those of the vertical cavity surface emitting laser 10 according to the first embodiment.

In the vertical cavity surface emitting laser 50, the tunnel junction layer 31 consisting of a p-type semiconductor layer 31A having a high impurity concentration, which is $p^+$-GaN, and an n-type semiconductor layer 31B having a high impurity concentration, which is $n^+$-GaN, is provided on the p-type semiconductor layer 18.

The tunnel junction layer 31 has a columnar mesa shape. For example, the tunnel junction layer 31 has a layer thickness of 20 nm and a diameter of 4 $\mu$m (center axis CX). The tunnel junction layer 31 is formed by etching the p-type semiconductor layer 31A and the n-type semiconductor layer 31B, and the p-type semiconductor layer 18, for example, at a depth of 25 nm.

The tunnel junction layer 31 is embedded by an n-type semiconductor layer 32 (second n-type semiconductor layer) which is n-GaN.

A semiconductor DBR 35 (second DBR) consisting of n-AlInN and n-GaN is provided on the n-type semiconductor layer 32. The semiconductor DBR 35 consists of, for example, 46 pairs of n-AlInN/GaN.

An outer peripheral portion of each semiconductor layer and the semiconductor DBR 35 are etched to reach the inside of the n-type semiconductor layer 13, and the surface emitting laser having a columnar mesa structure coaxial with the center axis CX of the tunnel junction layer 31 is formed.

The n-electrode 27 is formed on a surface of the outer peripheral portion of the n-type semiconductor layer 13. In addition, a p-electrode 36 having a diameter larger than that of the tunnel junction layer 31 in a top view (when viewed from a direction perpendicular to the semiconductor DBR 35) and having a circular opening coaxial with the center axis CX is formed on the semiconductor DBR 35.

An antireflection (AR) coating 29 consisting of two layers of $Nb_2O_5/SiO_2$ is formed on a rear surface of the vertical cavity surface emitting laser 50.

Although the tunnel junction layer 31 is composed of the $p^+$-GaN layer and the $n^+$-GaN layer, a semiconductor layer having a different composition, such as GaInN and the like, may be used. For example, Mg can be used as the impurity (dopant) in the $p^+$-GaN layer. The doping concentration of Mg is preferably $4 \times 10^{19}$ cm$^3$ or more. High doping of $1 \times 10^{18}$ cm$^3$ or more is preferable for the $n^+$-GaN layer or the $n^+$-GaInN layer.

(Correspondence Relationship with Examples 1 to 3)

The first and second conditions in the vertical cavity surface emitting laser 50 can be considered in the same manner as in a case of the vertical cavity surface emitting laser 10 according to the first embodiment.

Specifically, in a vertical cavity surface emitting laser 50 of Example 4, the interface between the semiconductor DBR 35 and the n-type semiconductor layer 32 corresponds to a phase reference (phase = 0). The node of the standing wave is located at the reference position.

The n-type semiconductor layer 32 (second n-type semiconductor layer) corresponds to the spacer layer 24 in the above-described examples. More specifically, a portion of the n-type semiconductor layer 32 between the tunnel junction layer 31 and the semiconductor DBR 35 corresponds to the spacer layer 24 according to the first embodiment.

Further, the tunnel junction layer 31 corresponds to the transparent conductive film (ITO) 22 according to the first embodiment, and it is preferable that there is one node ND of the standing wave SW in the tunnel junction layer 31 ($N_{ND} = 1$).

Further, a condition for the number of nodes ND and the number of anti-nodes AN of the standing wave SW included in the electron blocking layer 17 and the p-type semiconductor layer 18, which are p regions (first condition) and a condition for the number of nodes ND and the number of anti-nodes AN included in the final barrier layer 16 (second condition) are the same as the conditions in the first embodiment.

With the vertical cavity surface emitting laser 50 according to the second embodiment, even in a case in which the doping concentration of the impurity (dopants) is reduced, high injection efficiency can be maintained. Therefore, it is possible to provide a vertical cavity light emitting element in which the operating current can be reduced and the reliability (lifespan) of the element is improved.

As described above in detail, according to the present invention, it is possible to provide the vertical cavity light emitting element having the low threshold current density, the high light emission efficiency, and having the improved lifespan.

Description of Reference Numerals

10, 50: vertical cavity surface emitting laser
11: substrate
12: semiconductor DBR (first reflective mirror)
13: n-type semiconductor layer
15: active layer
15B: blocking layer (barrier layer)
15W: quantum well layer (well layer)
16: intermediate layer (LB)
17: electron blocking layer
18: p-type semiconductor layer
21: insulating film
22: transparent conductive film
24: spacer layer
25: dielectric DBR (second reflective mirror)
31: tunnel junction layer
31A: p-type semiconductor layer with high impurity concentration
31B: n-type semiconductor layer with high impurity concentration
32: n-type semiconductor layer (second n-type semiconductor layer)
35: semiconductor DBR

**Claims**

1. A vertical cavity light emitting element of a III-V nitride semiconductor, comprising:

a first reflective mirror;
an n-type semiconductor layer formed on the first reflective mirror;
an active layer provided on the n-type semiconductor layer;

an intermediate layer provided on the active layer;
an electron blocking layer provided on the intermediate layer and containing Al in a composition;
a p-type semiconductor layer provided on the electron blocking layer and doped with an impurity; and
a second reflective mirror provided on the p-type semiconductor layer,
wherein the electron blocking layer is a composition gradient layer in which an Al composition decreases in a direction away from the active layer, and
an impurity concentration of the impurity has a peak in the electron blocking layer and decreases in a direction toward the active layer from the peak.

2. The vertical cavity light emitting element according to Claim 1,
wherein holes are generated in the electron blocking layer by piezoelectric polarization, and a hole concentration generated by the piezoelectric polarization is $5.0 \times 10^{18}$ atoms/cm$^3$ or more.

3. The vertical cavity light emitting element according to Claim 1,
wherein an average composition gradient of the Al composition in the electron blocking layer is 0.9%/nm or more.

4. The vertical cavity light emitting element according to Claim 1,
wherein the impurity concentration has a bottom at a position corresponding to an interface between the p-type semiconductor layer and the electron blocking layer.

5. The vertical cavity light emitting element according to Claim 1,
wherein an impurity concentration of the impurity at an interface between the electron blocking layer and the intermediate layer is less than $1.0 \times 10^{19}$ cm$^{-3}$.

6. The vertical cavity light emitting element according to Claim 1,
wherein an impurity concentration at an interface between the electron blocking layer and the intermediate layer is less than $5.0 \times 10^{18}$ cm$^{-3}$.

7. The vertical cavity light emitting element according to Claim 1,
wherein the intermediate layer is an undoped layer.

8. A vertical cavity light emitting element comprising:

a first reflective mirror;

an n-type semiconductor layer provided on the first reflective mirror;

an active layer provided on the n-type semiconductor layer and consisting of a multiple quantum well;

an intermediate layer provided on a final quantum well of the active layer;

an electron blocking layer provided on the intermediate layer and containing Al in a composition;

a p-type semiconductor layer provided on the electron blocking layer and doped with an impurity;

a spacer layer provided on the p-type semiconductor layer; and

a second reflective mirror provided on the spacer layer,

wherein the electron blocking layer is a composition gradient layer in which an Al composition decreases in a direction away from the active layer,

an impurity concentration of the impurity has a peak in the electron blocking layer and decreases in a direction toward the active layer from the peak,

the number of anti-nodes and the number of nodes of a standing wave, which is caused by light emitted from the active layer, included in the electron blocking layer and the p-type semiconductor layer are each 0 or 1, and

when layer thicknesses of the intermediate layer and the active layer are denoted by $H_{fb}$ and $H_{qw}$, respectively, a refractive index of the intermediate layer is denoted by $n_{fb}$, and an equivalent refractive index of the active layer is denoted by $n_{qw}$, the active layer and the intermediate layer satisfy a following expression,

$$\frac{H_{qw}}{2\left(\dfrac{\lambda}{n_{qw}}\right)} + \frac{H_{fb}}{\left(\dfrac{\lambda}{n_{fb}}\right)} \geq 0.4$$

9. The vertical cavity light emitting element according to Claim 8,
   wherein the number of nodes included in the intermediate layer is 2 or more, and the number of anti-nodes included in the intermediate layer is 1 or more.

**Amended claims under Art. 19.1 PCT**

1. (Amended) A vertical cavity light emitting element of a III-V nitride semiconductor, comprising:

   a first reflective mirror;
   an n-type semiconductor layer formed on the first reflective mirror;
   an active layer provided on the n-type semiconductor layer;
an intermediate layer provided on the active layer;
an electron blocking layer provided on the intermediate layer and containing Al in a composition;
a p-type semiconductor layer provided on the electron blocking layer and doped with an impurity; and
a second reflective mirror provided on the p-type semiconductor layer,
wherein the electron blocking layer is a composition gradient layer having a composition gradient in which an Al composition decreases in a direction away from the active layer, and
an impurity concentration of the impurity has a peak at a vicinity of an interface between the electron blocking layer and the p-type semiconductor layer, and decreases in a direction toward the active layer.

2. The vertical cavity light emitting element according to Claim 1,
   wherein holes are generated in the electron blocking layer by piezoelectric polarization, and a hole concentration generated by the piezoelectric polarization is $5.0 \times 10^{18}$ atoms/cm$^3$ or more.

3. The vertical cavity light emitting element according to Claim 1,
   wherein an average composition gradient of the Al composition in the electron blocking layer is 0.9%/nm or more.

4. The vertical cavity light emitting element according to Claim 1,
   wherein the impurity concentration has a bottom at a position corresponding to an interface between the p-type semiconductor layer and the electron blocking layer.

5. The vertical cavity light emitting element according to Claim 1,
   wherein an impurity concentration of the impurity at an interface between the electron blocking layer and the intermediate layer is less than $1.0 \times 10^{19}$ cm$^{-3}$.

6. The vertical cavity light emitting element according to Claim 1,
   wherein an impurity concentration at an interface between the electron blocking layer and the intermediate layer is less than $5.0 \times 10^{18}$ cm$^{-3}$.

7. The vertical cavity light emitting element according to Claim 1,
   wherein the intermediate layer is an undoped layer.

8. (Amended) A vertical cavity light emitting element comprising:

a first reflective mirror;

an n-type semiconductor layer provided on the first reflective mirror;

an active layer provided on the n-type semiconductor layer and consisting of a multiple quantum well;

an intermediate layer provided on a final quantum well of the active layer;

an electron blocking layer provided on the intermediate layer and containing Al in a composition;

a p-type semiconductor layer provided on the electron blocking layer and doped with an impurity;

a spacer layer provided on the p-type semiconductor layer; and

a second reflective mirror provided on the spacer layer,

wherein the electron blocking layer is a composition gradient layer having a composition gradient in which an Al composition decreases in a direction away from the active layer,

an impurity concentration of the impurity has a peak at a vicinity of an interface between the electron blocking layer and the p-type semiconductor layer, and decreases in a direction toward the active layer,

the number of anti-nodes and the number of nodes of a standing wave, which is caused by light emitted from the active layer, included in the electron blocking layer and the p-type semiconductor layer are each 0 or 1, and

when layer thicknesses of the intermediate layer and the active layer are denoted by $H_{fb}$ and $H_{qw}$, respectively, a refractive index of the intermediate layer is denoted by $n_{fb}$, and an equivalent refractive index of the active layer is denoted by $n_{qw}$, the active layer and the intermediate layer satisfy a following expression,

$$\frac{H_{qw}}{2\left(\dfrac{\lambda}{n_{qw}}\right)} + \frac{H_{fb}}{\left(\dfrac{\lambda}{n_{fb}}\right)} > 0.4$$

9. The vertical cavity light emitting element according to Claim 8,

wherein the number of nodes included in the intermediate layer is 2 or more, and the number of anti-nodes included in the intermediate layer is 1 or more.

**Statement under Art. 19.1 PCT**

1. Basis of Amendment

The amendments of the claims/Claim 1 and Claim 8 are each based on the matters described in the original specification and the like as will be described later.

(1) The amendment of "the electron blocking layer is a composition gradient layer having a composition gradient in which an Al composition decreases in a direction away from the active layer" (the underlined part represents an amended part, and the same applies hereinafter) is based on the description in the specification/[0041] and [0042] and the drawings/FIG. 3.

(2) The amendment of "an impurity concentration of the impurity has a peak at a vicinity of an interface between the electron blocking layer and the p-type semiconductor layer, and decreases in a direction toward the active layer, ..." is based on the description in the specification/[0043] and [0044] and the drawings/FIG. 3.

2. Purpose of Amendment

None of References 1 to 7 published in the International Search Report describe the invention specific matters related to the amendments.

Reference 1 does not describe the composition distribution of the AlGaN layer 21 (corresponding to the electron blocking layer) and the concentration distribution of the p-type dopant.

Although Reference 2 describes the Al composition of the carrier block layer 26 (see paragraphs [0061] to [0063] of Reference 2), Reference 2 does not describe the Mg concentration.

According to Reference 3, since the Al composition ratios of two adjacent electron blocking layers are different from each other without being continuous, the piezoelectric polarization does not occur.

Reference 4 does not describe the Al composition and the Mg concentration only in the electronic block layer (see paragraph [0027] of Reference 4).

Reference 5 does not describe a type of a vertical cavity laser having a short cavity length (Reference 5: see paragraph [0120] and FIG. 10B).

Reference 6 does not disclose that the optical output is increased while the impurity concentration is reduced by having a peak in the electron blocking layer (Reference 6: FIG. 8).

Reference 7 does not disclose that the impurity concentration in the electron blocking layer 18 has a peak on the p semiconductor layer side, not on the active layer side (Reference 7: [0140] to [0142], Fig.

10).

FIG.1

# FIG.2

## FIG.3

# FIG.4

FIG.5

## FIG.6A

AI COMPOSITION

LOW

HIGH

POLARIZATION
CHARGE

EBL17

HOLES

ELECTRONS

# FIG.6B

# FIG.6C

# FIG.7

# FIG.8A

## FIG.8B

## FIG.8C

# FIG.9

[Ex.1]

# FIG.10

FIG.11

# EP 4 583 330 A1

<table>
<tr><td colspan="2">INTERNATIONAL SEARCH REPORT</td><td>International application No.<br><br>**PCT/JP2023/034557**</td></tr>
</table>

**A.    CLASSIFICATION OF SUBJECT MATTER**

*H01S 5/183*(2006.01)i; *H01S 5/343*(2006.01)i
FI:    H01S5/183; H01S5/343 610

According to International Patent Classification (IPC) or to both national classification and IPC

**B.    FIELDS SEARCHED**

Minimum documentation searched (classification system followed by classification symbols)

H01S5/00-5/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | WO 2020/230669 A1 (STANLEY ELECTRIC CO., LTD.) 19 November 2020 (2020-11-19)<br>    paragraphs [0013]-[0063], fig. 1, 2 | 1-9 |
| Y | WO 2019/146478 A1 (SONY SEMICONDUCTOR SOLUTIONS CORP.) 01 August 2019 (2019-08-01)<br>    paragraphs [0013]-[0031], [0057]-[0063], fig. 1, 10-13 | 1-9 |
| Y | JP 2021-27194 A (NIKKISO CO., LTD.) 22 February 2021 (2021-02-22)<br>    paragraphs [0011]-[0035], fig. 1, 2 | 1-9 |
| Y | JP 2008-47688 A (KABUSHIKI KAISHA TOSHIBA) 28 February 2008 (2008-02-28)<br>    paragraph [0027] | 1-9 |
| Y | WO 2018/003551 A1 (PANASONIC INTELLECTUAL PROPERTY MANAGEMENT CO., LTD.) 04 January 2018 (2018-01-04)<br>    paragraphs [0051]-[0090], fig. 1-4 | 1-9 |
| Y | JP 2003-273473 A (NICHIA CORP.) 26 September 2003 (2003-09-26)<br>    paragraphs [0085]-[0087], fig. 8 | 1-9 |

✓ Further documents are listed in the continuation of Box C.    ✓ See patent family annex.

| | |
|---|---|
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search<br><br>**01 November 2023** | Date of mailing of the international search report<br><br>**14 November 2023** |
|---|---|
| Name and mailing address of the ISA/JP<br><br>**Japan Patent Office (ISA/JP)**<br>**3-4-3 Kasumigaseki, Chiyoda-ku, Tokyo 100-8915**<br>**Japan** | Authorized officer<br><br><br>Telephone No. |

Form PCT/ISA/210 (second sheet) (January 2015)

## INTERNATIONAL SEARCH REPORT

| International application No. |
| --- |
| **PCT/JP2023/034557** |

### C. DOCUMENTS CONSIDERED TO BE RELEVANT

| Category* | Citation of document, with indication, where appropriate, of the relevant passages | Relevant to claim No. |
| --- | --- | --- |
| Y | WO 2020/158254 A1 (PANASONIC SEMICONDUCTOR SOLUTIONS CO., LTD.) 06 August 2020 (2020-08-06)<br>paragraphs [0035]-[0132], fig. 1-8 | 1-9 |
| Y | WO 2006/109418 A1 (MITSUBISHI ELECTRIC CORP.) 19 October 2006 (2006-10-19)<br>paragraphs [0009], [0017]-[0033], fig. 1-3 | 2 |
| Y | JP 2016-157910 A (FUJI XEROX CO., LTD.) 01 September 2016 (2016-09-01)<br>paragraphs [0028]-[0035], fig. 4-6 | 8-9 |
| A | US 2013/0028283 A1 (KAISER, W. et al.) 31 January 2013 (2013-01-31)<br>entire text, all drawings | 1-9 |

Form PCT/ISA/210 (second sheet) (January 2015)

## INTERNATIONAL SEARCH REPORT
### Information on patent family members

International application No.

**PCT/JP2023/034557**

| Patent document cited in search report | | | Publication date (day/month/year) | Patent family member(s) | | | Publication date (day/month/year) |
|---|---|---|---|---|---|---|---|
| WO | 2020/230669 | A1 | 19 November 2020 | (Family: none) | | | |
| WO | 2019/146478 | A1 | 01 August 2019 | US | 2021/0066887 | A1 | |
| | | | | paragraphs [0043]-[0061], [0087]-[0093], fig. 1, 10-13 | | | |
| | | | | CN | 111386638 | A | |
| JP | 2021-27194 | A | 22 February 2021 | US | 2021/0043802 | A1 | |
| | | | | paragraphs [0023]-[0056], fig. 1, 2 | | | |
| | | | | CN | 112349820 | A | |
| JP | 2008-47688 | A | 28 February 2008 | (Family: none) | | | |
| WO | 2018/003551 | A1 | 04 January 2018 | US | 2019/0148916 | A1 | |
| | | | | paragraphs [0067]-[0104], fig. 1-4 | | | |
| | | | | CN | 109417276 | A | |
| JP | 2003-273473 | A | 26 September 2003 | US | 2005/0127391 | A1 | |
| | | | | paragraphs [0097]-[0099], fig. 8 | | | |
| | | | | US | 2008/0203418 | A1 | |
| | | | | WO | 2003/041234 | A1 | |
| | | | | EP | 1453160 | A1 | |
| | | | | CN | 1484880 | A | |
| | | | | KR | 10-0597532 | B1 | |
| WO | 2020/158254 | A1 | 06 August 2020 | US | 2021/0359163 | A1 | |
| | | | | paragraphs [0072]-[0168], fig. 1-8 | | | |
| WO | 2006/109418 | A1 | 19 October 2006 | US | 2009/0026489 | A1 | |
| | | | | paragraphs [0009], [0041]-[0057], fig. 1-3 | | | |
| | | | | CN | 101156285 | A | |
| JP | 2016-157910 | A | 01 September 2016 | US | 2016/0248228 | A1 | |
| | | | | paragraphs [0037]-[0039], fig. 4-6 | | | |
| | | | | CN | 105914581 | A | |
| US | 2013/0028283 | A1 | 31 January 2013 | GB | 2493186 | A | |
| | | | | WO | 2013/014457 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021184456 A
- JP 2022041738 A
- JP 6830098 B
- JP 6192378 B